(19) Europäisches Patentamt
European Patent Office
Office européen des brevets

(11) EP 0 721 269 B1

(12) **EUROPÄISCHE PATENTSCHRIFT**

(45) Veröffentlichungstag und Bekanntmachung des Hinweises auf die Patenterteilung:
**20.08.2008 Patentblatt 2008/34**

(51) Int Cl.:
*H04L 25/02* *(2006.01)*

(21) Anmeldenummer: **95119724.3**

(22) Anmeldetag: **14.12.1995**

(54) **Integrierte CMOS-Schaltung**

CMOS circuit

Circuit CMOS

(84) Benannte Vertragsstaaten:
**BE CH DE ES FR GB IT LI NL SE**

(30) Priorität: **22.12.1994 DE 4445846**

(43) Veröffentlichungstag der Anmeldung:
**10.07.1996 Patentblatt 1996/28**

(73) Patentinhaber: **Naxos Data LLC**
**Las Vegas NV 89119 (US)**

(72) Erfinder:
• **Banniza, Thomas**
**D-71282 Hemmingen (DE)**

• **Preisach, Helmut**
**D-74385 Pleidelsheim (DE)**

(74) Vertreter: **Harris, Ian Richard et al**
**D Young & Co**
**120 Holborn**
**London EC1N 2DY (GB)**

(56) Entgegenhaltungen:
**US-A- 4 868 482      US-A- 5 296 756**

EP 0 721 269 B1

**Beschreibung**

Die Erfindung betrifft eine CMOS-Schaltung nach dem Oberbegriff des Anspruchs 1. Allgemein bekannt ist die Bedingung, bei der Übertragung elektrischer Signale über Leitungen, die Ausgangsimpedanz der Signalquelle und die Eingangsimpedanz der Signalsenke an den Wellenwiderstand der Leitung anzupassen, um eine reflexionsfreie Übertragung zu gewährleisten. Bei der technischen Realisierung dieser Bedingung, beispielsweise bei der Übertragung hochfrequenter Signale über eine Leitung zu einer integrierten Schaltung, ist zu berücksichtigen, daß die Leitung möglichst nahe am Ende der Leitung abgeschlossen wird. Jedes Leitungsstück ohne angepaßten Abschlußwiderstand und jede Verzweigung der Leitung erzeugt Reflexionen des Signals, die zu einer Verschlechterung der Übertragungsqualität führen. So bestehen die allgemein bekannten Forderungen, die Leitungen ohne Verzweigung bis zum Anschluß der integrierten Schaltung zu führen, den Abschlußwiderstand möglichst nahe an dem Anschluß der integrierten Schaltung anzuordnen und den Wert des Abschlußwiderstandes möglichst genau an den Wellenwiderstand der Leitung anzupassen. Allerdings treten bei der Realisierung dieser Forderungen einige Probleme auf.

So haben hochintegrierte Schaltungen in der Regel viele Eingänge, die mit einem Widerstand abgeschlossen werden müssen. Bei modernen Gehäusen hochintegrierter Schaltungen haben die Anschlüsse nur noch einen Abstand von 0,5 mm. Selbst wenn nur jeder zweite Anschluß mit einem Signal belegt wird, sind auf der Leiterplatte die Signalleitungen mit einem Mittenabstand von 1 mm zu führen. Es bedarf also geometrisch sehr kleiner Abschlußwiderstände und spezieller Montagetechniken, derartig eng geführte Signalleitungen möglichst dicht am Anschluß der integrierten Schaltung mit einem Abschlußwiderstand zu beschalten. Allgemein wird dieses Problem dadurch gelöst, daß die Leiterbahndichte verringert wird und damit der Nachteil entsteht, daß die Bestückungsdichte auf der Leiterplatte geringer als an sich möglich wird. Die verringerte Leiterbahndichte hat weiterhin den Nachteil, daß der Einsatz von integrierten Schaltungen mit kleinem Gehäuse und sehr geringen Abständen der Anschlüsse unmöglich wird.

Selbst wenn der Abschlußwiderstand unmittelbar am Anschluß der integrierten Schaltung angeordnet wird, verbleibt ein Stück nicht angepaßt abgeschlossener Leitung, nämlich die Leitung durch das Gehäuse und der Bonddraht zur integrierten Schaltung. Beide Leitungsteile haben eine undefinierte Impedanz und stellen ersatzweise ein LCR-Glied dar, das ein unerwünschtes Überschwingen des Signals bewirken kann.

Aus dieser Problemstellung resultiert die der Erfindung zugrunde liegende Aufgabe, einerseits eine Möglichkeit für die Anordnung eines Abschlußwiderstandes anzugeben, die die zuvor beschriebenen Nachteile vermeidet und andererseits eine Möglichkeit zu bieten, den Abschlußwiderstand an unterschiedliche Wellenwiderstände anpassen zu können, wobei die Einflüsse von Betriebstemperatur, Änderungen der Versorgungsspannung und herstellungsprozeßbedingte Abweichungen der integrierten Schaltung bei der Bemessung des Abschlußwiderstandes berücksichtigt werden sollen.

Diese Aufgabe wird erfindungsgemäß gelöst durch eine Integrierte CMOS-Schaltung nach der Lehre des Anspruchs 1, bzw. 4.

Weitere Ausgestaltungen der Erfindung sind den Unteransprüchen und der nachfolgenden Beschreibung zu entnehmen.

Eine integrierte CMOS-Schaltung mit einer Referenzschaltung, einem Referenzwiderstand und einer Mess-Schaltung, mittels derer eine Anzahl genau gleicher Widerstände nachgebildet wird, ist bereits bekannt aus der US-Patentschrift 4,868,482.

Das Wesen der Erfindung besteht darin, daß der Abschlußwiderstand nunmehr Teil der integrierten Schaltung ist und gegenüber bisher bekannten technischen Lösungen näher an der Signalsenke angeordnet ist. Die Signalleitung wird ohne Verzweigung über den Anschluß der integrierten Schaltung bis zum Signalempfänger geführt. Praktisch ist die Leitung zwischen dem ersten aktiven Schaltelement des Signalempfängers und dem Abschlußwiderstand kürzer als 1 mm und wird damit hochfrequenztechnisch für Signalfrequenzen bis mindestens 1 GHz nicht als Stichleitung wirksam. Da der externe diskrete Widerstand zum Leitungsabschluß entfällt, entfallen damit auch der Bestückungsvorgang und die damit verbundenen Kosten. Außerdem wird vorteilhafterweise die für den Abschlußwiderstand benötigte Fläche auf der Leiterplatte gespart. Durch Regelung einer Steuerspannung, die den Wert des Abschlußwiderstands bestimmt, kann der Leitungsabschluß an unterschiedliche Umgebungsbedingungen angepaßt werden.

Die Erfindung wird nachstehend an einem Ausführungsbeispiel erläutert. In der dazugehörigen Zeichnung zeigen

Fig. 1 ein Kennlinienfeld eines n-Kanal-Feldeffekttransistors vom Anreicherungstyp nach dem Stand der Technik,

Fig. 2 einen vergrößerten Ausschnitt um den Koordinatenursprung aus Fig. 1,

Fig. 3 eine Prinzipschaltung für die Verwendung eines Feldeffekttransistors als Abschlußwiderstand einer Leitung,

Fig. 4 ein Schaltbild, einer Schaltungsanordnung für einen als Abschlußwiderstand dienenden Feldeffekttransistor in einem CML-Pegel-System,

Fig. 5 ein Blockschaltbild für die Erzeugung der Gate-Source-Spannung $U_{GS}$,

Fig. 6      ein Schaltbild für eine erste Ausführungsform einer Meßschaltung,

Fig. 7      ein Schaltbild für eine zweite Ausführungsform der Meßschaltung,

Fig. 8      ein Schaltbild für eine erste Ausführungsform einer Regelschaltung,

Fig. 9      ein Schaltbild für eine zweite Ausführungsform der Regelschaltung und

Fig. 10     ein Schaltbild für einen Digital-Analog-Wandler.

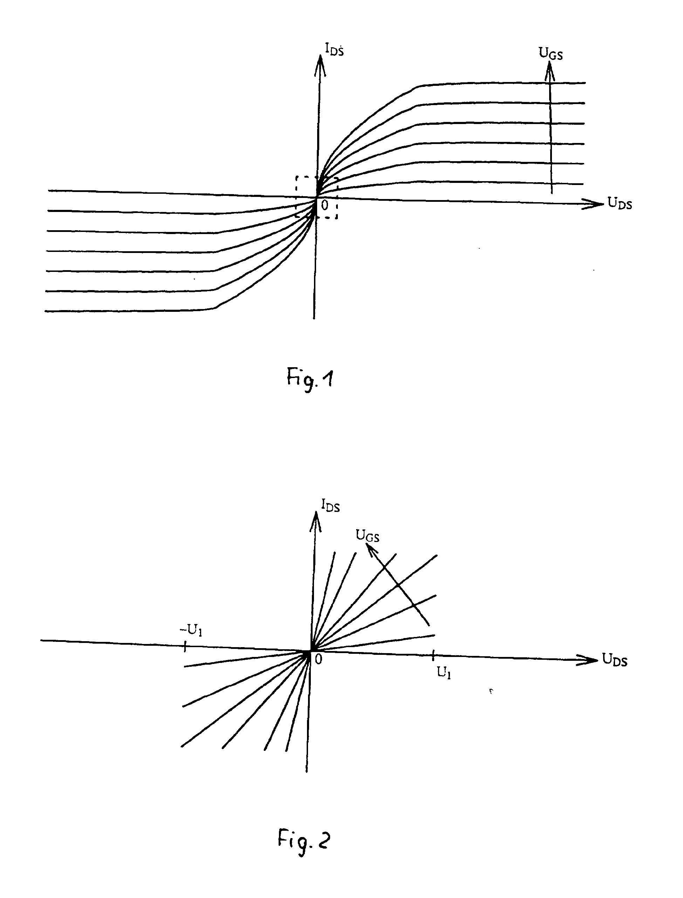

Bei der Erfindung wird der in Fig. 1 und Fig. 2 dargestellte und bekannte physikalische Sachverhalt ausgenutzt, daß sich ein Feldeffekttransistor, im folgenden mit FET bezeichnet, im Anlaufbereich der UI-Kennlinie der Drain-Source-Strecke näherungsweise wie ein Widerstand verhält. Der Wert dieses Widerstandes ist über die Gate-Source-Spannung des FET steuerbar, vgl. U. Tietze, Ch. Schenk: Halbleiterschaltungstechnik, Springer-Verlag Berlin, Heidelberg, New York, London, Paris, Tokyo 1986, Seite 99-101. In Fig. 1 ist das Kennlinienfeld eines n-Kanal-FET vom Anreicherungstyp dargestellt, für den auch die folgenden Ausführungen gelten. Die Erklärungen gelten sinngemäß auch für andere FET-Typen, lediglich die geänderten Vorzeichen der Spannungen und Ströme sind zu beachten. Der in Fig. 1 um den Koordinatenursprung durch gestrichelte Linien markierte Bereich ist in Fig. 2 vergrößert dargestellt. In diesem Bereich ist die Abhängigkeit des Drain-Source-Stromes $I_{DS}$ im wesentlichen linear von der Drain-Source-Spannung $U_{DS}$ abhängig. Die Steigung

$$\frac{dU_{DS}}{dI_{DS}}$$

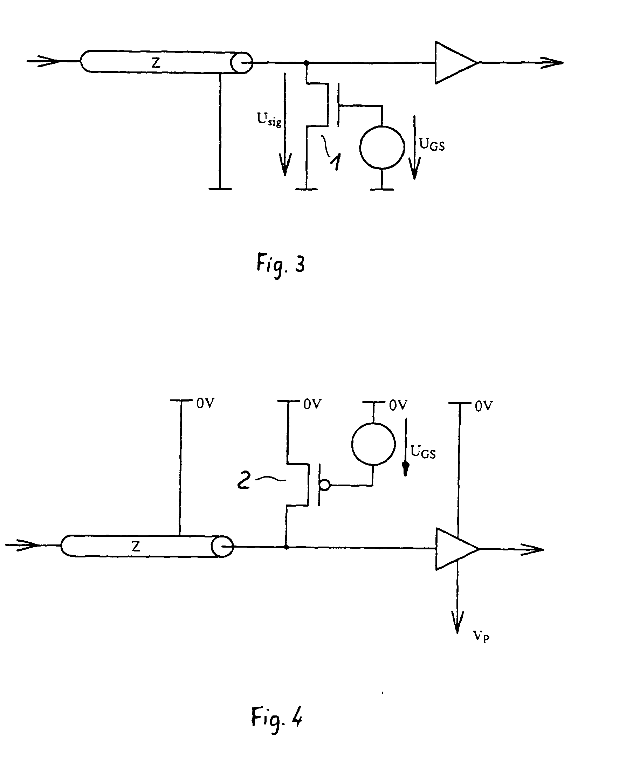

der Kennlinen ist abhängig von der Steuerspannung, der Gate-Source-Spannung $U_{GS}$, so daß mit dieser Spannung der Widerstand des Drain-Source-Kanals gesteuert werden kann. Die Kennlinien sind, wie in Fig. 2 dargestellt, im Bereich $-U_1 \leq U_{DS} \leq U_1$ linear. Technisch liegt bei CMOS-Prozessen die Grenze für $U_1$ bei $U_1 \pm 1{,}2$ V. Wenn die Signalspannung $U_{sig}$ auf einer Leitung innerhalb des linearen Bereiches $-U_1 \leq U_{sig} \leq U_1$ liegt, so kann die Drain-Source-Strecke des FET1 als Abschlußwiderstand der Leitung gemäß Fig. 3 eingesetzt werden. Damit der Widerstand des FET1 mit dem Wellenwiderstand Z der Leitung übereinstimmt, muß durch Wahl der Gate-Source-Spannung $U_{GS}$ ein entsprechender Widerstand eingestellt werden. Die Begrenzung der Signalspannung $U_{sig}$ auf den linearen Bereich $-U_1 \leq U_{sig} \leq U_1$ ist technisch keine Einschränkung, da für Breitbandinterfaces ohnehin ein möglichst geringer Signalhub angestrebt wird, um die Verlustleistung, die durch die Umladung der Leitung bei jeder Signalflanke bedingt ist, für ein Breitbandinterface möglichst klein zu halten. Es ist beispielsweise eine Interfacedefinition für ein Current-Mode-Logic-Pegel-System, kurz CML-Pegel-System, technisch üblich, bei dem die logische "1" durch eine Spannung von OV und die logische "0" je nach Einsatzfall durch eine Spannung im Bereich zwischen -400mV und -1200mV dargestellt wird. Fig. 4 zeigt die Schaltungsanordnung eines als Abschlußwiderstand dienenden FET in einem CML-Pegel-System. Da die Bezugsspannung des Systems, hier OV, die positive Versorgungsspannung der integrierten Schaltung ist, wird hier ein p-Kanal-FET 2 eingesetzt. Die Versorgungsspannung der integrierten Schaltung ist beispielsweise $V_P = -5V$, so daß die Gate-Source-Spannung $U_{GS}$ von der Versorgungsspannung abgeleitet werden kann und eine besondere Hilfsspannung nicht erforderlich ist.

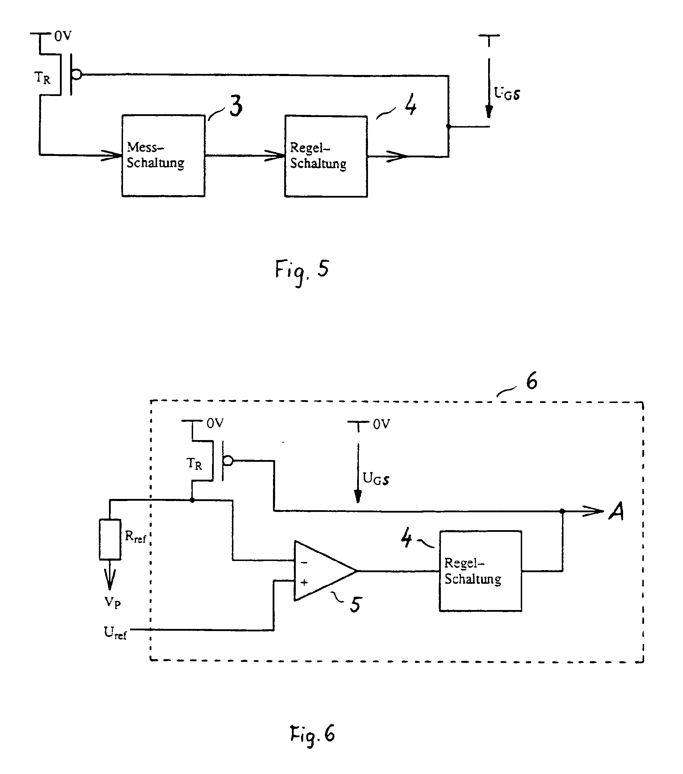

Zwar ist der Einsatz eines FET als steuerbarer Widerstand in einem Spannungsteiler an sich bekannt, vgl. U. Tietze, Ch. Schenk a.a.O., der Einsatz als Abschlußwiderstand einer Leitung ist jedoch an besondere Forderungen gebunden. Die Gate-Source-Spannung $U_{GS}$ kann nicht auf einen festen Wert eingestellt werden, da der exakte Wert, der für einen bestimmten Widerstand, für den Kanalwiderstand des FET, benötigt wird, von der integrierten CMOS-Schaltung abhängig ist. Um jedoch bei unterschiedlichen Bedingungen eine Anpassung des Kanalwiderstandes an den Wellenwiderstand der Leitung zu erreichen, muß der entsprechende Wert der Gate-Source-Spannung $U_{GS}$ gemäß Fig. 5 über eine Meßschaltung 3 ermittelt und über eine Regelschaltung 4 auf dem benötigten Wert gehalten werden. Obwohl integrierte Schaltungen praktisch häufig mehr als 10 Eingänge haben, deren Signalleitungen abgeschlossen werden müssen, wird die Meßschaltung 3 und die Regelschaltung 4 nur einmal pro integrierter Schaltung benötigt, um die Gate-Source-Spannung $U_{GS}$ für die als Abschlußwiderstände wirkenden FET $T_R$ einstellen zu können, da sich die Einflüsse des Herstellungsprozesses, der Betriebstemperatur und der Versorgungsspannung auf alle Transistoren der integrierten CMOS-Schaltung gleichartig auswirken.

Um den korrekten Wert der Gate-Source-Spannung $U_{GS}$ zu bestimmen, werden zwei Ausführungsformen der Meßschaltung 3 angegeben.

In einer ersten Ausführungsform gemäß Fig. 6 besteht die Meßschaltung 3 aus dem als Abschlußwiderstand wirkenden FET $T_R$, im folgenden kurz Transistor $T_R$, aus einem Referenzwiderstand $R_{ref}$ und aus einem Komparator 5. Dabei sind der Transistor $T_R$ und der Komparator 5 Bestandteile der integrierten CMOS-Schaltung 6, im folgenden kurz integrierte Schaltung genannt, während sich der Referenzwiderstand $R_{ref}$ außerhalb der integrierten Schaltung 6 befindet und eine für den Komparator 5 benötigte Referenzspannung $U_{ref}$ der integrierten Schaltung 6 von außen zugeführt wird. Der Transistor

$T_R$ und der Referenzwiderstand $R_{ref}$, dessen Wert hinreichend genau, beispielsweise auf 1 % genau, bekannt ist, bilden einen Spannungsteiler, dessen Abgriff mit dem ersten Eingang des Komparators 5 verbunden ist. Am zweiten Eingang des Komparators 5 liegt die Referenzspannung $U_{ref}$. Das Ergebnis des Vergleichs der Ausgangsspannung des Spannungsteilers mit der Referenzspannung $U_{ref}$ wird der Regelschaltung 4 zugeführt, die die Gate-Source-Spannung $U_{Gs}$ für den Transistor $T_R$ erzeugt und abhängig vom Ergebnis des Vergleichs nachstellt. Alle weiteren Transistoren der auf einem Chip integrierten Schaltung 6, die ebenfalls Abschlußwiderstände bilden, werden über den Anschluß A der Schaltungsanordnung mit der gleichen Gate-Source-Spannung $U_{GS}$ versorgt. Da auf einem Chip der Herstellungsprozeß, die Versorgungsspannung und die Temperatur im wesentlichen gleich sind, wird der Kanalwiderstand der Drain-Source-Strecke der Transistoren auf den gewünschten Wert geregelt.

Wenn die Referenzspannung $U_{ref}$ der integrierten Schaltung 6 von außen zugeführt wird, wird die Abhängigkeit von der Versorgungsspannung $V_P$ dadurch vermieden, daß die Referenzspannung $U_{ref}$ nicht von einer Absolut-Spannungsquelle erzeugt wird, sondern mittels Spannungsteiler ebenfalls aus der Versorungsspannung $V_P$ abgeleitet wird. Der Spannungsteiler kann auch integriert werden, da das Verhältnis zweier integrierter Widerstände sehr genau und reproduzierbar hergestellt werden kann.

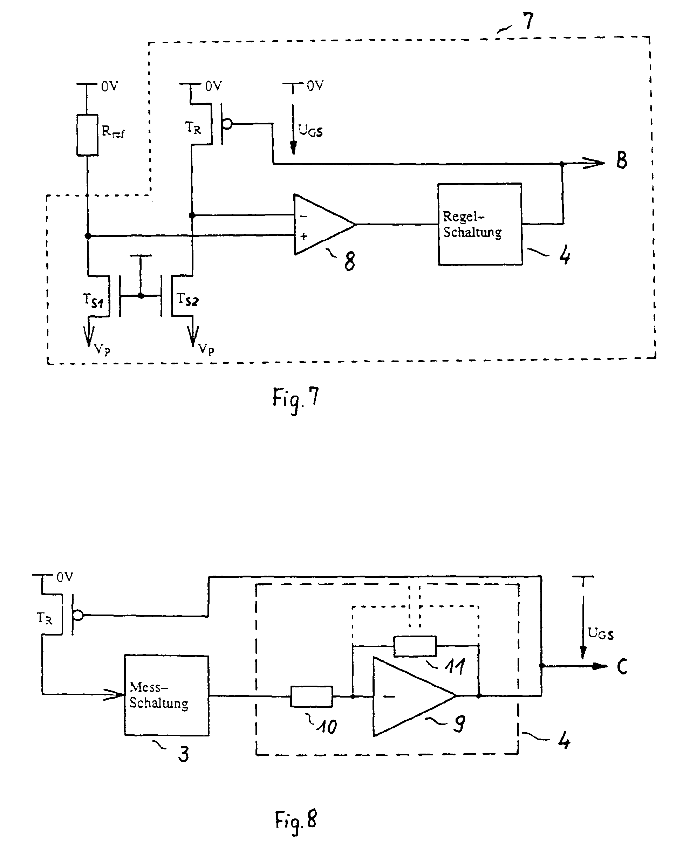

Eine zweite Ausführungsform der Meßschaltung 3 zeigt Fig. 7. Danach besteht die Meßschaltung aus einem Referenzwiderstand $R_{ref}$ außerhalb der integrierten Schaltung 7 und innerhalb der integrierten Schaltung 7 aus einem als Abschlußwiderstand wirkenden Transistor $T_R$ und aus einem ersten FET. $T_{S1}$ und einem zweiten FET $T_{S2}$ sowie aus einem Komparator 8. Der erste FET $T_{S1}$ wirkt wie eine Stromquelle und ist mit dem Referenzwiderstand $R_{ref}$ verbunden, dessen Wert beispielsweise auf 1 % genau bekannt ist. Der zweite FET $T_{S2}$ wirkt ebenfalls wie eine Stromquelle und ist mit dem als Abschlußwiderstand wirkenden Transistor $T_R$ verbunden. Der erste FET $T_{S1}$ und der zweite FET $T_{S2}$ haben gleiche Form und Größe, so daß jeweils der gleiche Strom durch den Referenzwiderstand $R_{ref}$ und den Transistor $T_R$ fließt. Der Spannungsabfall über dem Referenzwiderstand $R_{ref}$ und der Spannungsabfall über dem Transistor $T_R$ werden mit Hilfe des Komparators 8 verglichen. Das Vergleichsergebnis wird der Regelschaltung 4 zugeführt, mit der die Gate-Source-Spannung $U_{GS}$ des Transistors $T_R$ solange nachgeregelt wird, bis die Differenz der Spannungsabfälle über dem Referenzwiderstand $R_{ref}$ und über dem Transistor $T_R$ minimal wird. Dann ist der Kanalwiderstand des Transistors $T_R$ gleich dem Referenzwiderstand $R_{ref}$. Durch die Wahl des Referenzwiderstandes $R_{ref}$ kann somit sehr genau der gewünschte und vom Transistor $T_R$ gebildete Abschlußwiderstand der Leitung eingestellt werden. Alle weiteren Transistoren der auf einem Chip integrierten Schaltung 7, die ebenfalls Abschlußwiderstände bilden, werden über den Anschluß B der Schaltungsanordnung mit der gleichen Gate-Source-Spannung $U_{GS}$ versorgt. Da auf einem Chip der Herstellungsprozeß, die Versorgungsspannung und die Temperatur im wesentlichen gleich sind, wird der Kanalwiderstand der Drain-Source-Strecke der Transistoren auf den gewünschten Wert geregelt.

Bei beiden Ausführungsformen der Meßschaltung 3 gemäß Fig. 6 und Fig. 7 erzeugt die Regelschaltung 4 in Abhängigkeit vom Vergleichsergebnis der jeweiligen Komparatoren 5, 8 die erforderliche Gate-Source-Spannung $U_{GS}$. Die Regelschaltung 4 wirkt dabei als Proportional/Integral-Regler. Je nach gewünschter Genauigkeit und den Möglichkeiten, die die Herstellungsprozeß der integrierten Schaltung erlaubt, wird die Gate-Source-Spannung $U_{GS}$ auf unterschiedliche Weise erzeugt.

Fig. 8 zeigt eine Schaltungsanordnung für die Regelschaltung 4, die in analoger Schaltungstechnik ausgeführt ist. Gemäß Fig. 8 besteht die Regelschaltung 4 aus einem Operationsverstärker 9, einem ersten Widerstand 10 und einem zweiten Widerstand 11. Der erste Widerstand 10 ist dem Eingang des Operationsverstärkers 9 vorgeschaltet, der zweite Widerstand 11 mit einer in der Fig. 8 gestrichelt eingezeichneten parasitären Kapazität verbindet den Eingang mit dem Ausgang des Operationsverstärkers 9 und bestimmt als Gegenkopplungswiderstand den Wert der Ausgangsspannung und damit die Gate-Source-Spannung $U_{GS}$. Diese Schaltungsvariante in analoger Schaltungstechnik ist dann von Vorteil, wenn die Realisierung des Operationsverstärkers 9 durch den angewendeten Herstellungsprozeß mit den geforderten Eigenschaften möglich ist und wenn die Verteilung der Gate-Source-Spannung $U_{GS}$ über den Anschluß C der Schaltungsanordnung zu den als Abschlußwiderstände wirkenden Transistoren so ausgeführt werden kann, daß das Einkoppeln von Störungen auf die dafür empfindlichen Leitungen mit Analogsignalen vermieden wird. Diese Bedingungen werden von integrierten Schaltungsanordnungen auf kleineren Chips in gemischter Bipolar/CMOS-Technologie erfüllt. Der Operationsverstärker 9 muß für diesen Einsatzfall insbesondere einen möglichst geringen Eingangsstrom und eine möglichst große Leerlaufverstärkung haben, um die gewünschte Integratorfunktion zu haben, und die Aussteuerbarkeit des Ausgangssignals muß den benötigten Wertebereich für die Gate-Source-Spannung $U_{GS}$ abdecken.

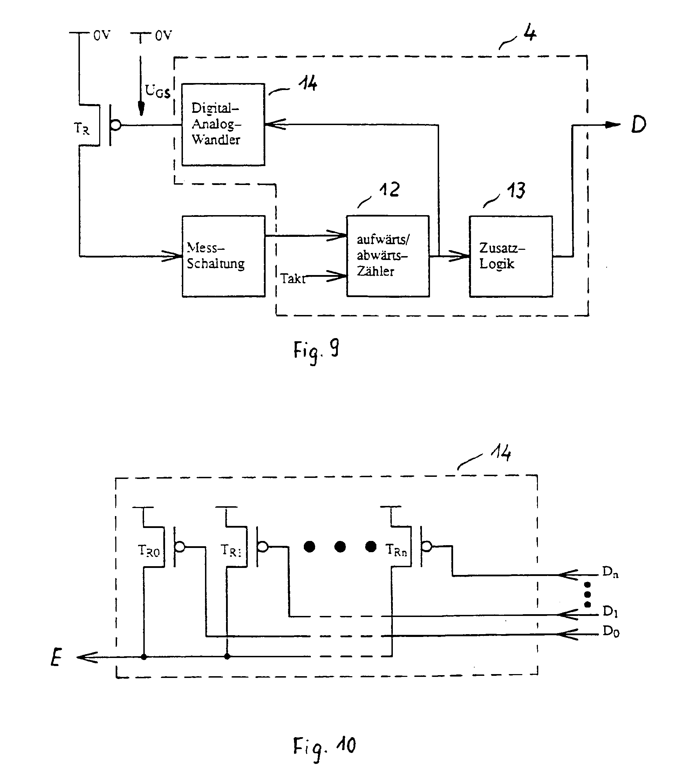

Eine Realisierungsform der Regelschaltung 4 in digitaler Schaltungstechnik zeigt Fig. 9. Die Regelschaltung 4 besteht aus einem Aufwärts/Abwärts-Zähler 12, aus einer Zusatzlogikschaltung 13 und aus einem Digital-Analog-Wandler 14. Die Ausgangsspannung des jeweiligen Komparators 5, 8 der Meßschaltung 3 wird je nach Ergebnis des Vergleichs der Eingangsspannung des Komparators 5, 8 dazu verwendet, den Zählerstand des Aufwärts/Abwärts-Zählers 12 um eins zu erhöhen oder zu erniedrigen. Am Ausgang des Aufwärts/Abwärts-Zählers 12 entsteht ein digitales Abbild der Gate-Source-Spannung $U_{GS}$. Dieser Digitalwert wird mit einem Digital-Analog-Wandler 14 in einem Analogwert umgesetzt. Damit die Analogsignale führenden Leitungen kurz werden, wird der Digital-Analog-Wandler 14 in der Nähe des den Abschlußwiderstand bildenden Transistors $T_R$ angeordnet. Wenn die Regelung kontinuierlich erfolgt, schwankt der Zählerstand des Aufwärts/Abwärts-Zählers 12 ständig, da der Komparator 5, 8 als Vergleichsergebnis nur Werte für "zu klein" oder "zu groß", nicht aber für "gleich" liefert. Wenn der vom Aufwärts/Abwärts-Zähler 12 gelieferte Digitalwert zur Einstellung des Abschlußwiderstandes benutzt wird, wird der Widerstandswert des Abschlußwiderstandes mit der Änderung des Digitalwertes im letzten Bit moduliert. Diese Modulation des Widerstandswertes kann eine unerwünschte Modulation der Nutzspannung am Abschlußwiderstand verursachen. Um die Modulation zu vermeiden, ist es zweckmäßig, die Ansteuerung des als Leitungsabschluß verwendeten Transistors durch eine Zusatzlogik 13 von der Regelschleife zu trennen. Das erfolgt dadurch, daß mittels einer digitalen Vergleicher-Schaltung mit Speicher ein zweiter Digitalwert bestimmt wird, der den größeren oder auch den kleineren der beiden Werte darstellt, zwischen denen der Aufwärts/Abwärts-Zähler 12 schwankt. Auf diese Weise wird die ständige Änderung vermieden, und der zweite Digitalwert ändert sich nur noch dann, wenn der Aufwärts/Abwärts-Zähler 12 zum ersten Mal zwischen zwei neuen Werten schwankt. Der Ausgangswert der Zusatzlogikschaltung 13 wird dann über den Anschluß D der Schaltungsanordnung in der Nähe der als Abschlußwiderstand arbeitenden Transistoren für jeden einzelnen Transistor oder für eine Transistorgruppe in den Analogwert für die Gate-Source-Spannung $U_{GS}$ umgesetzt. Die Wortbreite des Digitalsignals bestimmt die Genauigkeit der Einstellung des Abschlußwiderstandswertes.

Der Digital-Analog-Wandler 14 kann gemäß Fig. 10 durch parallel geschaltete Transistoren $T_{R0}$, $T_{R1}$..., $T_{Rn}$, die einzeln von den Elementen $D_0$, $D_1$..., $D_n$ der Binärinformation aktiviert werden können, realisiert werden. Da der Digital-Analog-Wandler 14 Bestandteil der Regelschleife aus dem den Abschlußwiderstand bildenden Transistor $T_R$, aus der Meßschaltung 3 und aus der Regelschaltung 4 ist, ist es nicht erforderlich, daß der Digital-Analog-Wandler 14 einen gegebenen Digitalwert in eine genau definierte Spannung umsetzt. Vielmehr muß er eine streng monoton steigende Spannung für einen steigenden Digitalwert erzeugen, und die Gesamttoleranzen, die sich durch die Unbestimmtheit des Digital-Analog-Wandlers 14 in der Regelschleife ergeben, müssen von dem Regelvorgang aufgefangen werden. Alle einen Abschlußwiderstand bildenden Transistoren müssen von einem Digital-Analog-Wandler 14 gleichen Typs angesteuert werden, so daß gesichert ist, daß in jedem Fall für einen bestimmten Digitalwert der gleiche, nicht notwendigerweise genau vorhersagbare, Analogwert zur Verfügung gestellt wird.

Gemäß Fig. 10 ist der den Abschlußwiderstand der Leitung bildende Transistor $T_R$ in eine Parallelschaltung mehrerer Transistoren $T_{R0}$, $T_{R1}$...$T_{Rn}$ aufgeteilt. Je nachdem, welche und wieviele Transistoren $T_{R0}$, $T_{R1}$...$T_{Rn}$ eingeschaltet sind, ergibt die Parallelschaltung die Wirkung eines Transistors mit variablem Kanalwiderstand. Dabei ist durch die digitale Ansteuerung der Transistoren die Gate-Source-Spannung entweder gleich der Versorgungsspannung $V_P$ oder gleich 0V. Es wird also nicht bei einem Transistor $T_R$ die Gate-Source-Spannung $U_{GS}$ verändert, sondern durch die jeweiligen konstanten digitalen Werte der Gate-Source-Spannung $U_{GS}$ die Größe des resultierenden Transistors variiert. Der Kanalwiderstand des Gesamttransistors $T_R$ kann somit über die Binärinformation $D_0$, $0_1$...$D_n$ eingestellt werden. Der Anschluß E des Digital-Analog-Wandlers 14 führt direkt zu der anzupassenden Leitung.

Die Größe der Transistoren $T_{R0}$, $T_{R1}$...$T_{Rn}$ hängt von der Art der Binärinformation $D_0$, $D_1$...$D_n$ ab. Wird dort ein Binärcode verwendet, müssen die Transistoren $T_{R0}$, $T_{R1}$...$T_{Rn}$ ebenfalls binär gestuft sein. Es ist aber auch möglich, daß die Binärinformation $D_0$, $D_1$...$D_n$ durch ein prioritätscodiertes Datenwort dargestellt wird, das bedeutet, daß lediglich die Zahl der auf "0" liegenden Leitungen maßgebend für den eingestellten Wert des resultierenden Transistors $T_R$ ist. In diesem Fall sind die parallel zu schaltenden Transistoren $T_{R0}$, $T_{R1}$...$T_{Rn}$ gleich groß. Die Gesamtzahl n der Transistoren $T_{R0}$, $T_{R1}$...$T_{Rn}$ hängt von der geforderten Auflösung ab und gibt die notwendige Wortbreite der Binärinformation $D_0$, $D_1$...$D_n$ vor.

**Patentansprüche**

1. Schaltungsanordnung für den Abschluß einer zu einer integrierten CMOS-Schaltung (6, 7) führenden Leitung (Z), und die Schaltungsanordnung folgendes aufweist einen mit der Leitung verbundenen Feldeffekttransistor ($T_R$), wobei die integrierte CMOS-Schaltung (6, 7) den Feldeffekttransistor ($T_R$) beinhaltet, wobei die Drain-Source-Strecke des Feldeffekttransistors ($T_R$) mit der Leitung (Z) verbunden ist, wobei der Feldeffekttransistor ($T_R$) den Abschlußwiderstand für die Leitung (Z) bereitstellt bzw. bildet,

eine Meßschaltung (3), die so ausgestaltet ist, daß sie den Unterschied zwischen einer den Kanalwiderstand des Feldeffekttransistors ($T_R$) steuernden Spannung und einer Referenzspannung ($U_{ref}$) feststellt, und eine Regelschaltung (4), die so ausgestaltet ist, daß sie die Spannung am Gateanschluß des Feldeffekttransistors ($T_R$) in Reaktion auf das Ausgangssignal der Meßschaltung (3) reguliert oder einstellt, **dadurch gekennzeichnet, daß**

die Regelschaltung (4) eine Integratorschaltung und eine analoge Ausgangsschaltung beinhaltet, wobei die Integratorschaltung einen Digital-Analog-Wandler (14) aufweist, wobei die Integratorschaltung weiterhin einen Aufwärts-/Abwärts-Zähler (12) aufweist, wobei die Regelschaltung weiterhin eine mit dem Ausgang des Aufwärts-/Abwärts-Zählers (12) verbundene Logikschaltung (13) aufweist, wobei die Logikschaltung so ausgestaltet ist, dass sie Schwankungen um einen von dem Aufwärts-/Abwärts-Zähler (12) gegebenen digitalen Wert verhindert.

2. Schaltungsanordnung nach Anspruch 1, wobei der Digital-Analog-Wandler (14) weiterhin folgendes aufweist:

   einen Parallelanschluß einer Mehrzahl von FETs ($TR_0$, $TR_1...TR_n$), deren Gateanschlüsse jeweils so ausgestaltet sind, daß sie eine Mehrzahl von Bitsignalen ($D_0$, $D_1...D_n$) empfangen, wobei die Mehrzahl von Bitsignalen ein Datenwort bildet, wobei die Mehrzahl von Bitsignalen bestimmt, welcher der FETs ($TR_0$, $TR_1...TR_n$) jeweils zum Gesamtwiderstand des Parallelanschlusses beiträgt.

3. Schaltungsanordnung nach Anspruch 1 oder 2, wobei die Meßschaltung (3) weiterhin folgendes aufweist:

   einen Komparator (5), der folgendes umfaßt:

   einen ersten Eingang, der mit einer Referenzspannungsquelle ($U_{ref}$) außerhalb der integrierten CMOS-Schaltung (6, 7) verbunden ist, und
   einen zweiten Eingang, der mit dem Verbindungspunkt der Drain-Source-Strecke des Feldeffekttransistors ($T_R$) verbunden ist, wobei eine Versorgungsspannungsquelle ($V_P$) außerhalb der integrierten CMOS-Schaltung (6, 7) eine Spannung über einen Referenzwiderstand ($R_{ref}$) an den zweiten Eingang liefert, wodurch ein Spannungsteiler gebildet wird, wobei der Referenzwiderstand ($R_{ref}$) nicht in der integrierten CMOS-Schaltung (6, 7) enthalten ist.

4. Verfahren zum Abschließen einer mit einer integrierten CMOS-Schaltung (6,7) verbundenen Leitung (Z), wobei das Verfahren aufweist:

   Verbinden eines Feldeffekttransistors ($T_R$) mit der Leitung (Z), wobei der Feldeffekttransistor ($T_R$) in die integrierte CMOS Schaltung eingebaut ist, wobei der Drain-Source-Strecke des Feldeffekttransistors ($T_R$) mit der Leitung (Z) verbunden ist und wobei der Feldeffekttransistor ($T_R$) den Abschlusswiderstand für die Leitung (Z) bereitstellt bzw. bildet, wobei der Abschlußwiderstand des Feldeffekttransistors ($T_R$) der charakteristischen Impedanz der Leitung (Z) entspricht,
   Verwenden einer Messschaltung (3), um einen Unterschied zwischen einer den Kanalwiderstand des Feldeffekttransistors ($T_R$) steuernden Spannung und einer Referenzspannung ($U_{ref}$) festzustellen, und
   Verwenden einer Regelschaltung (4), um die Spannung am Gateanschluß des Feldeffekttransistors ($T_R$) in Reaktion auf das Ausgangssignal der Messschaltung (3) einzustellen,

wobei die Regelschaltung (4) eine Integratorschaltung und eine analoge Ausgangsschaltung beinhaltet, wobei die Integratorschaltung einen Digital-Analog-Wandler (14) aufweist, wobei die Integratorschaltung weiterhin einen Aufwärts-/Abwärts-Zähler (12) aufweist, wobei die Regelschaltung weiterhin eine mit dem Ausgang des Aufwärts-/Abwärts-Zählers (12) verbundene Logikschaltung (13) aufweist, wobei die Logikschaltung so ausgestaltet ist, dass sie Schwankungen um einen von dem Aufwärts-/Abwärts-Zähler (12) gegebenen digitalen Wert verhindert.

5. Verfahren nach Anspruch 4, wobei das Einstellen der Gatespannung weiterhin folgendes umfaßt:

   an der Meßschaltung (3) Vergleichen einer außerhalb der integrierten Schaltung (6, 7) erzeugten Versorgungsspannung ($V_P$) mit einer innerhalb der integrierten Schaltung (6, 7) erzeugten Spannung, was zur Ausgabe einer Meßgröße führt,
   Regulieren der Spannung am Gateanschluß des Feldeffekttransistors ($T_R$) durch die Regelschaltung (4) in Reaktion auf die durch die Meßschaltung (3) ausgegebene Meßgröße, wobei der durch den Feldeffekttransistor ($T_R$) gebildete Abschlußwiderstand auf einem an den Wert der Leitung (Z) angepaßten Wert gehalten wird, und zwar ungeachtet Variationen bei der Herstellung der integrierten Schaltung (6, 7), Variationen der Betriebstemperatur und Variationen der Versorgungsspannung ($V_P$).

**Claims**

1. A circuit arrangement for terminating a line (Z) leading to an integrated CMOS-circuit (6, 7), and the circuit arrangement has the following:

a field effect transistor ($T_R$) connected to the line, wherein the integrated CMOS-circuit (6, 7) contains the field effect transistor ($T_R$), wherein the Drain-Source-Path of the field effect transistor ($T_R$) is connected to the line (Z), wherein the field effect transistor ($T_R$) prepares, or forms, the terminating resistance for the line (Z),

a test circuit (3) which so designed that it establishes the difference between a voltage which controls the resistance of the channel of the field effect transistor ($T_R$), and a reference voltage ($U_{ref}$), and

a regulating circuit (4) which is so designed that it regulates or sets the voltage at the gate terminal of the field effect transistor ($T_R$) in response to the output signal of the test circuit (3), **characterised in that**

the regulating circuit (4) contains an integrator circuit and an analog output circuit, wherein the integrator circuit has a digital-analog-converter (14),

wherein the integrator circuit further has an up/down counter (12), wherein the regulating circuit further has a logic circuit (13) which is connected to the output of the up/down counter (12), wherein the logic circuit is so designed that it prevents fluctuations about a digital value determined by the up/down counter (12).

2. A circuit arrangement according to Claim 1, wherein the Digital-Analog-Converter (14) further has the following:

a parallel connection of a plurality of FETs ($TR_0$, $TR_1...TR_n$), the gate terminals of which are so designed that they receive a plurality of bit signals ($D_0$, $D_1...D_n$), wherein the plurality of bit signals forms a data word, wherein the plurality of bit signals determines which of the respective FET's ($TR_0$, $TR_1...TR_n$) contributes to the total resistance of the parallel connection.

3. A circuit arrangement according to Claim 1 or 2, wherein the test circuit (3) further has the following:

a comparator (5) which comprises the following:

a first input which is connected to a reference voltage source ($U_{ref}$) outside the integrated CMOS-circuit (6, 7), and

a second input which is connected to the point of connection of the Drain-Source-Path of the field effect transistor ($T_R$), wherein a distribution voltage source ($V_P$) outside the integrated CMOS-circuit (6, 7) delivers a voltage through a reference resistance ($R_{ref}$) to the second input, whereby a voltage distributor is formed, wherein the reference resistance ($R_{ref}$) is not contained in the integrated CMOS-circuit (6, 7).

4. A method for terminating a line (Z) connected to an integrated CMOS-circuit (6, 7), wherein the method has:

the connection of a field effect transistor ($T_R$) to the line (Z), wherein the field effect transistor ($T_R$) is incorporated within the integrated CMOS-circuit, wherein the Drain-Source-Path of the field effect transistor ($T_R$) is connected to the line (Z), and wherein the field effect transistor ($T_R$) prepares, or forms, the terminating resistance for the line (Z), wherein the terminating resistance of the field effect transistor ($T_R$) corresponds to the characteristic impedance of the line (Z),

the use of a test circuit (3) for establishing a difference between a voltage which controls the resistance of the channel of the field effect transistor ($T_R$) and a reference voltage ($U_{ref}$), and

the use of a regulating circuit (4) for setting the voltage at the gate terminal of the field effect transistor ($T_R$) in response to the output signal of the test circuit (3),

wherein the regulating circuit (4) contains an integrator circuit and an analog output circuit, wherein the integrator circuit has a Digital-Analog-Converter (14), wherein the integrator circuit further has an up/down counter (12),

wherein the regulating circuit further has a logic circuit (13) which is connected to the output of the up/down counter (12), wherein the logic circuit is so designed that it prevents fluctuations about a digital value determined by the up/down counter (12).

5. A method according to Claim 4, wherein the setting of the gate voltage further comprises the following:

at the test circuit (3) the comparison of a distribution voltage ($V_P$) generated outside the integrated circuit (6, 7) with a voltage generated inside the integrated circuit (6, 7), which results in the output of a measured variable,

the regulating of the voltage at the gate terminal of the field effect transistor ($T_R$) by the regulating circuit (4) in response to the measured variable emitted by the test circuit (3), wherein the terminating resistance formed by the field effect transistor ($T_R$) is kept to a value suited to the value of the line (Z), and, to be exact, regardless of variations during the production of the integrated circuit (6, 7), variations in operating temperature and variations in distribution voltage ($V_P$).

**Revendications**

1.  Circuit de terminaison d'une ligne (Z) conduisant à un circuit CMOS intégré (6, 7), lequel circuit de terminaison comporte :

    - un transistor à effet de champ ($T_R$) relié à la ligne, le circuit CMOS intégré (6, 7) contenant le transistor à effet de champ ($T_R$), la section drain - source du transistor à effet de champ ($T_R$) étant reliée à la ligne (Z) et le transistor à effet de champ ($T_R$) fournissant c'est-à-dire formant la résistance de terminaison pour la ligne (Z),
    - un circuit de mesure (3) qui est conçu de telle sorte qu'il détermine la différence entre une tension commandant la résistance de canal du transistor à effet de champ ($T_R$) et une tension de référence ($U_{ref}$), et
    - un circuit de régulation (4) qui est conçu de telle sorte qu'il régule ou règle la tension à la borne de grille du transistor à effet de champ ($T_R$) en réaction au signal de sortie du circuit de mesure (3),

    **caractérisé par le fait que**
    le circuit de régulation (4) contient un circuit intégrateur et un circuit de sortie analogique, le circuit intégrateur comportant un convertisseur numérique - analogique (14), le circuit intégrateur comportant aussi un compteur incrémentant ou décrémentant (12), le circuit de régulation comportant aussi un circuit logique (13) relié à la sortie du compteur incrémentant ou décrémentant (12), le circuit logique étant conçu de telle sorte qu'il empêche des variations autour d'une valeur numérique donnée par le compteur incrémentant ou décrémentant (12).

2.  Circuit selon la revendication 1, le convertisseur numérique - analogique (14) comportant aussi :

    un raccordement en parallèle d'une multiplicité de FET ($TR_0, TR_1, ..., TR_n$) dont les bornes de grille sont conçues chacune de telle sorte qu'elles reçoivent une multiplicité de signaux binaires ($D_0, D_1, ..., D_n$), la multiplicité des signaux binaires formant un mot de données, la multiplicité de signaux binaires déterminant lequel des FET ($TR_0, TR_1, ..., TR_n$) contribue respectivement à la résistance totale du raccordement en parallèle.

3.  Circuit selon la revendication 1 ou 2, le circuit de mesure (3) comportant aussi :

    un comparateur (5) qui comprend lui-même :

    une première entrée qui est reliée à une source de tension de référence ($U_{ref}$) à l'extérieur du circuit CMOS intégré (6, 7), et une deuxième entrée qui est reliée au point de jonction de la section drain - source du transistor à effet de champ ($T_R$), une source de tension d'alimentation ($V_P$) à l'extérieur du circuit CMOS intégré (6, 7) fournissant une tension par l'intermédiaire d'une résistance de référence ($R_{ref}$) à la deuxième entrée, ce qui forme un diviseur de tension, la résistance de référence ($R_{ref}$) n'étant pas contenue dans le circuit CMOS intégré (6, 7).

4.  Procédé de terminaison d'une ligne (Z) reliée à un circuit CMOS intégré (6, 7), lequel procédé comporte :

    - la liaison d'un transistor à effet de champ ($T_R$) à la ligne (Z), le transistor à effet de champ ($T_R$) étant agencé dans le circuit CMOS intégré, la section drain - source du transistor à effet de champ ($T_R$) étant reliée à la ligne (Z) et le transistor à effet de champ ($T_R$) fournissant c'est-à-dire formant la résistance de terminaison pour la ligne (Z), la résistance de terminaison du transistor à effet de champ ($T_R$) correspondant à l'impédance caractéristique de la ligne (Z),
    - l'utilisation d'un circuit de mesure (3) pour déterminer une différence entre une tension commandant la résistance de canal du transistor à effet de champ ($T_R$) et une tension de référence ($U_{ref}$), et
    - l'utilisation d'un circuit de régulation (4) pour régler la tension à la borne de grille du transistor à effet de champ ($T_R$) en réaction au signal de sortie du circuit de mesure (3),

    le circuit de régulation (4) contenant un circuit intégrateur et un circuit de sortie analogique, le circuit intégrateur comportant un convertisseur numérique - analogique (14), le circuit intégrateur comportant aussi un compteur incrémentant ou décrémentant (12), le circuit de régulation comportant aussi un circuit logique (13) relié à la sortie du compteur incrémentant ou décrémentant (12), le circuit logique étant conçu de telle sorte qu'il empêche des variations autour d'une valeur numérique donnée par le compteur incrémentant ou décrémentant (12).

5.  Procédé selon la revendication 4, le réglage de la tension de grille comprenant aussi :

    - dans le circuit de mesure (3), la comparaison d'une tension d'alimentation ($V_P$) produite à l'extérieur du circuit intégré (6, 7) à une tension produite à l'intérieur du circuit intégré (6, 7), ce qui entraîne la sortie d'une grandeur mesurée,

- la régulation de la tension à la borne de grille du transistor à effet de champ ($T_R$) par le circuit de régulation (4) en réaction à la grandeur mesurée fournie par le circuit de mesure (3),

la résistance de terminaison formée par le transistor à effet de champ ($T_R$) étant maintenue à une valeur adaptée à la valeur de la ligne (Z) et ce en dépit de variations lors de la fabrication du circuit intégré (6, 7), variations de la température de fonctionnement et variations de la tension d'alimentation ($V_P$).

Fig. 1

Fig. 2

10

$U_{sig}$

$U_{GS}$

1

Fig. 3

0V    0V    0V    0V

$U_{GS}$

2

Z

$v_P$

Fig. 4

0V

$T_R$

3

Mess-
Schaltung

4

Regel-
Schaltung

$U_{GS}$

Fig. 5

6

0V

$T_R$

0V

$U_{GS}$

$R_{ref}$

$V_P$

$U_{ref}$

−

+

5

4

Regel-
Schaltung

A

Fig. 6

Fig. 7

Fig. 8

0V    0V

$U_{GS}$

$T_R$

Digital-
Analog-
Wandler

14

Mess-
Schaltung

Takt

aufwärts/
abwärts-
Zähler

12

Zusatz-
Logik

13

4

D

Fig. 9

14

$T_{R0}$   $T_{R1}$   ● ● ●   $T_{Rn}$

$D_n$

$D_1$

$D_0$

E

Fig. 10

14

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 4868482 A

### In der Beschreibung aufgeführte Nicht-Patentliteratur

- **U. TIETZE.** Ch. Schenk: Halbleiterschaltungstechnik. Springer-Verlag, 1986, 99-101